# EUROPEAN PATENT APPLICATION

(11) **EP 4 174 926 A1**
(43) Date of publication of application: **03.05.2023**
(21) Application number: 22204824.1
(22) Date of filing: 31.10.2022
(51) Int. Cl.: H01L 23/00, H01L 31/02, H01L 31/18

(54) **BONDING METHODS**

(30) Priority: 01.11.2021 GB 202115648
(71) Applicant: Lightricity Ltd, Oxford, Oxfordshire OX4 4GB (GB)
(72) Inventor: BELLANGER, Mathieu, Oxford, OX4 4GB (GB); KAUER, Matthias, Oxford, OX4 4GB (GB)
(74) Representative: Dehns

(57) **Abstract**

A method of bonding an electrical wire (102) to a semiconductor device (101) comprises contacting a tool (70) with a dielectric layer (126) of the semiconductor device (101) so as to mechanically create an opening (127) through the dielectric layer (126), and using a wire-bonding tip (72) to bond the electrical wire (102) to the device (101) through said opening (127).

## Description

### BACKGROUND OF THE INVENTION

The present invention relates to methods of bonding an electrical wire to a semiconductor device-for example, a semiconductor optoelectronic device such as a photovoltaic cell.

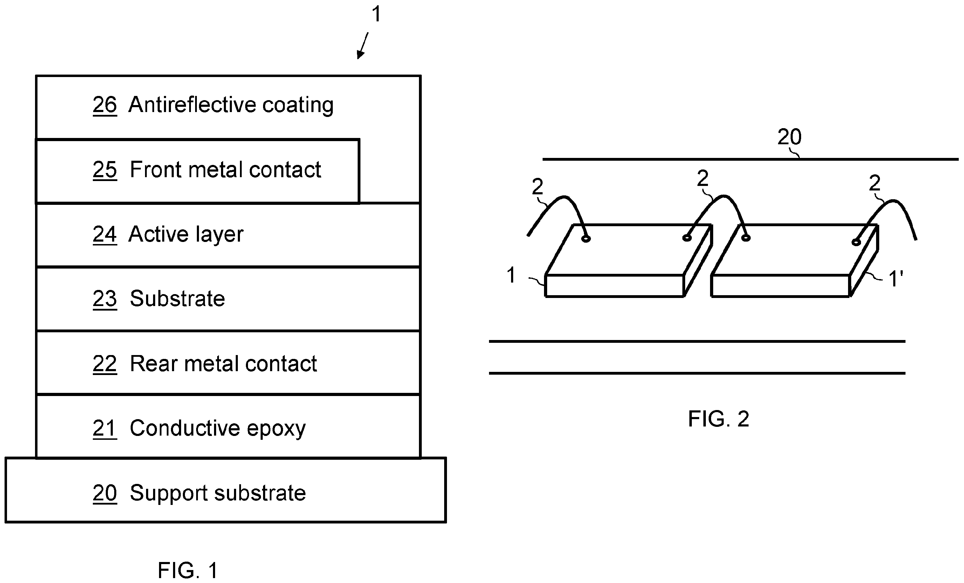

Photovoltaic cells are devices which convert light energy to electrical energy. Fig. 1 shows a schematic cross-section through part of a conventional photovoltaic cell 1. It comprises a layered structure formed of a support substrate 20 (e.g. printed circuit board), a conductive die-attach epoxy layer 21, a rear metal contact layer 22, a substrate layer 23 (e.g. silicon, glass, or a III-V substrate such as GaAs) having an active layer 24, a front metal contact layer 25, and an antireflective coating layer 26. The front metal contact layer 25 is deposited in a pattern (e.g. a grid) across part of the active layer 24 of the III-V substrate, so that sufficient light still reaches the active layer 24 through the light-receiving face of the photovoltaic cell 1.

The front and rear contact layers 22, 25 are provided to collect an electrical current generated by the active layer 24 when the cell 1 is exposed to light. The rear metal contact layer 22 may be directly coupled to a conductive track of the support substrate 20, via the conductive epoxy 21, while one or more metal wires can be bonded to the front metal contact layer 25. Fig. 2 shows a photovoltaic module formed of a series of such photovoltaic cells 1, 1', showing the front metal layers 25 interconnected by electrical wires 2.

In order to bond the wires 2 to the front metal contact layer 25, photolithography is used to etch openings at suitable points in the antireflective coating 26, to expose the front metal contacts. This process is illustrated in Figs. 3-8.

The antireflective coating 26 is first cleaned, and the cell 1 is then heated to remove any moisture from the surface. A flat layer of photoresist 27 is then applied onto the antireflective coating 26 by spin coating. This is followed by a prebaking step to remove excess solvent from the photoresist 27 to form the structure shown in Fig. 3. The photoresist 27 is then exposed to a pattern of intense light (e.g. UV), after which the exposed parts of the photoresist 27 can be removed by chemical treatment, to leave voids in the photoresist layer 27. One such void is shown in Fig. 4. This in turn results in a pattern of exposed areas of antireflective coating 26, allowing these regions of the antireflective coating 26 to be chemically removed, to expose the front metal contact layer 25, as depicted in Fig. 5. The remainder of the photoresist is then removed, resulting in the photovoltaic cell 1 having a structure as shown in Fig. 6.

Wire bonding is then used to bond metal wires 2 to the exposed front metal contacts 25, so as to electrically couple multiple cells 1, 1' in series or parallel or both. Though the main use of wire bonding is for chip on board (COB) assembly, i.e. the electrical connection of one or several cells to an external substrate (e.g. a Printed Circuit Board or PCB), wire bonding is also a well-known method of forming interconnections in semiconductor packaging (e.g. chip-scale and wafer-scale packaging). There are three main classes of wire bonding: wedge bonding, compliant bonding, and ball bonding. Of these, ball bonding is most commonly used to form electrical interconnections during semiconductor device fabrication.

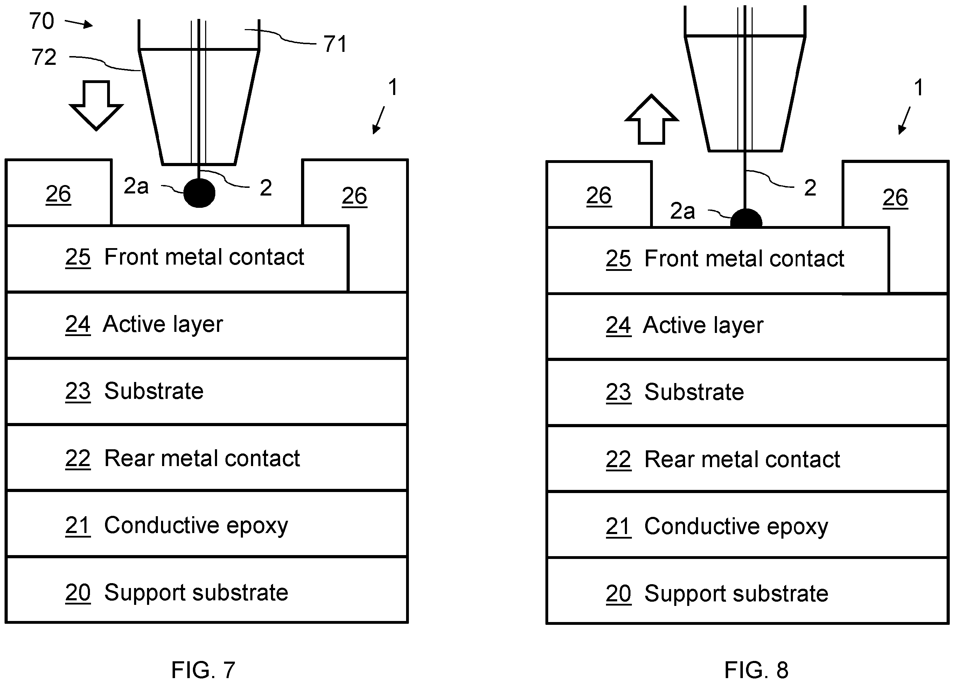

Ball bonding is performed using a wire bonding tool 70. The tool 70 has a capillary 71 that terminates at a bonding tip 72. A wire 2, typically made of gold, aluminium or copper, can be passed through the capillary 71. The wire 2 is subjected to a high-voltage electric charge (i.e. a spark), which causes the distal end of the wire to melt and form a ball 2a. Once the ball 2a has solidified, the wire bonding tip 72 is moved towards the front metal contact 25. This stage of the process is depicted in Fig. 8. The front metal contact 25 is heated and ultrasonic energy is applied to the wire bonding tip 72 by a transducer. As a result of this, a weld, known as a ball bond, is formed between the ball 2a at the end of the wire 2 and the front metal contact layer 25. This ball bond is depicted in Fig. 8. Once the ball bond has been formed, an amount of wire 2 is passed through the wire bonding tip 72, and the wire bonding tip 72 can be moved to a point, e.g. on another cell 1', where it is desired to attach an opposite end of the wire 2. The wire bonding tip 72 is then moved into contact with this other point and the wire bonding tip 72 used to force the wire to attach to the point by means of pressure. No ball is formed at this point, and therefore this bond is known as the tail bond or second bond. Once the second bond has been formed, a small further length of wire 2 is passed through the tip 72, and clamps are used to sever the wire, thereby leaving a length of wire 2 electrically coupling the front metal contact 25 to this second point. The wire 2 remaining in the tip 72 is ready to be used for the next bond.

However, photolithography is a time-consuming and expensive process which contributes to the cost of manufacturing photovoltaic cells and modules.

Embodiments of the present invention seek to provide a more efficient way of bonding a wire to a semiconductor device, such as a light-emitting diode (LED) device or a photovoltaic cell.

### SUMMARY OF THE INVENTION

When viewed from a first aspect, the invention provides a method of bonding an electrical wire to a semiconductor device, the method comprising:
contacting a tool with a dielectric layer of a semiconductor device so as to mechanically create an opening through the dielectric layer; and
using a wire-bonding tip to bond an electrical wire to the device through said opening.

When viewed from a second aspect, the invention provides an assembly comprising:
a semiconductor device; and
an electrical wire,
wherein the electrical wire has been bonded to the semiconductor device by:
contacting a tool with a dielectric layer of a semiconductor device so as to mechanically create an opening through the dielectric layer; and
using a wire-bonding tip to bond an electrical wire to the device through said opening.

When viewed from a third aspect, the invention provides an assembly comprising:
a semiconductor device; and
an electrical wire,
wherein:
the semiconductor device comprises a dielectric layer;
the dielectric layer has a mechanically-created opening in the dielectric layer; and
the electrical wire is bonded to the semiconductor device through said mechanically-created opening.

Thus it will be seen that, in accordance with embodiments of the invention, an opening in the dielectric layer is created mechanically by applying a tool to the dielectric layer so as to create the opening. Such contact can efficiently create an opening by displacing or removing dielectric material from the dielectric layer, in the vicinity of the tool tip. In a preferred set of embodiments, the tool comprises a wire-bonding tip (i.e., the tip of a wire-bonding tool). In some embodiments, the same wire-bonding tool is used to create the opening and then to bond the wire to the device through the opening. This dual use of the wire-bonding tip conveniently avoids the need to use different equipment or more complex processing steps to first form the opening, before the bonding can be performed, and can therefore save time and cost. However, even where a separate tool is used to create the opening, the process is still lower in cost than the conventional method using photolithography.

The semiconductor device may be a thin-film device. It may be configured to convert electrical energy into light energy or to convert light energy into electrical energy. It may be any type of semiconductor device, for example any type of semiconductor optoelectronic device, but in some embodiments it is a photovoltaic cell. In some embodiments, the device is a photovoltaic cell for indoor energy harvesting-e.g. arranged to output a current density below 1 mA/cm².

The dielectric layer may be an outermost layer of the device. It may define at least part of a light-receiving face or a light-emitting face of the device. The dielectric layer may be an antireflective coating. The dielectric layer may be an insulating layer. It may comprise Si₃N₄ or SiO₂. It may have a thickness of no more than 500 nm, or no more than 100 nm. It may have a thickness of at least 10 nm, or at least 40 nm. It may be in a range of 40 nm and 70 nm. The dielectric layer may have a refractive index of between 1 and 3, e.g. between 1.5 and 2.5.

The device may comprise a plurality of dielectric layers. These may be arranged as a stack of pairwise-touching layers. The stack of layers may together form an antireflective coating for the device. The opening may be created through the plurality of dielectric layers.

The device may comprise one or more layers comprising, or of, a group III-V material, such as GaAs. Each of these layers may be an active light-absorbing layer, an electrically conducting (e.g. doped) layer, an isolating (intrinsic) layer, or a light-emitting layer. In some embodiments the semiconductor optoelectronic device comprises an active light-absorbing or light-emitting layer comprising a group III-V material.

The wire-bonding tip may be a tip of a wire-bonding tool. It may be a tip of a capillary. It may comprise an opening for outputting the electrical wire. It may be a tip of a wedge-bonding tool or a compliant-bonding tool, but is preferably a ball-bonding tip. The wire-bonding tip may be used to bond the electrical wire using any one or more of: electrical energy (e.g. a spark), heat energy (e.g. applied to the device), mechanical energy (e.g. pressure applied through the tip), and sonic energy (e.g. ultrasonic vibration of the tip).

The electrical wire may be a metal wire. It may comprise, or be of, gold, aluminium or copper.

The device may comprise a metal contact, which may be provided as part of a front metal contact layer of the device. The wire-bonding tip may be used to bond the electrical wire to the metal contact, through the opening.

The tool used to form the opening may be any type of mechanical tip or probe or an indentation device. In some preferred embodiments, it is a wire-bonding tool. The tool may be elongate along and/or rotationally symmetric about an axis.

In a first set of embodiments, the opening is created by movement of the tool, e.g. wire-bonding tip, relative to the dielectric layer, perpendicular to the dielectric layer while the tool, e.g. wire-bonding tip, is in contact with the dielectric layer. The relative movement may be purely perpendicular (i.e. having no lateral component, parallel to the dielectric layer). The opening may be created at least partly by pressure applied perpendicularly to a plane of the dielectric layer. The opening may be an indentation.

In a second set of embodiments, the opening is created at least partly by lateral movement of the tool, e.g. wire-bonding tip, relative to the dielectric layer, while the tool, e.g. wire-bonding tip, is in contact with the dielectric layer. The opening may be created by moving the tool, e.g. wire-bonding tip, in a plane of the dielectric layer. The opening may be scratched in the dielectric layer. It may be formed as an elongate scratch. The opening may be created by moving the tool both perpendicularly and laterally, relative to the dielectric layer, while the tool is in contact with the dielectric layer.

In both sets of embodiments, creating the opening with the tool, e.g. wire-bonding tip, may comprise displacing dielectric material laterally (e.g. radially) away from the tool, e.g. from the wire-bonding tip. The displaced material may partly or entirely remain on the device (e.g. with none or only a negligible amount being removed by the tool). The material displaced by the tool may remain on the semiconductor device after the tool is removed. This contrasts with using wet etching, dry etching or laser ablation to create openings in an anti-reflective coating (ARC), as these approaches all physically remove all the ARC material. The resulting device may comprise a lip adjacent an edge of the opening, the lip comprising displaced dielectric-layer material. The lip may stand proud of a planar surface of the dielectric layer, which may be an outer surface of the device. The lip may surround part or all of a circumference of the opening.

The opening may have a shape that at least partly corresponds, or conforms, to a shape of the tool, e.g. the wire-bonding tip. In some embodiments, the tip may be frustoconical. The opening may have a cross-section, perpendicular to the dielectric layer, that is an isosceles trapezoidal cross-section (e.g. if perpendicular and/or lateral contact is made). The opening may be substantially rotationally symmetric (e.g. if only perpendicular force is applied), or it may be elongate in a plane of the dielectric layer (e.g. if lateral force is applied). The opening may be frustoconical (e.g. if purely perpendicular pressure is applied). The opening may widen in a direction away from the bond; it may be widest adjacent an outer face of the device and may be narrowest adjacent the wire bond (i.e. adjacent the metal contact).

The electrical wire may additionally be bonded to a second semiconductor device. The second device may comprise a dielectric layer having a mechanically-created opening, e.g. an opening created by the same wire-bonding tip. The wire may be bonded to the second device through said opening.

The electrical wire may additionally be bonded to an external substrate, for example a PCB, and may be configured to extract current or power from, or provide current or power to the device.

The assembly, e.g. the optoelectronic assembly, may comprise one or more further semiconductor devices (e.g. further photovoltaic cells), which may be electrically coupled to the first device (e.g. in series or in parallel).

Features of any aspect or embodiment described herein may, wherever appropriate, be applied to any other aspect or embodiment described herein. Where reference is made to different embodiments or sets of embodiments, it should be understood that these are not necessarily distinct but may overlap.

### BRIEF DESCRIPTION OF THE DRAWINGS

Certain preferred embodiments of the invention will now be described, by way of example only, with reference to the accompanying drawings, in which:
Fig. 1 is a schematic cross-section across part of a conventional photovoltaic cell;
Fig. 2 is a schematic perspective view of a conventional photovoltaic module comprising a series of interconnected photovoltaic cells;

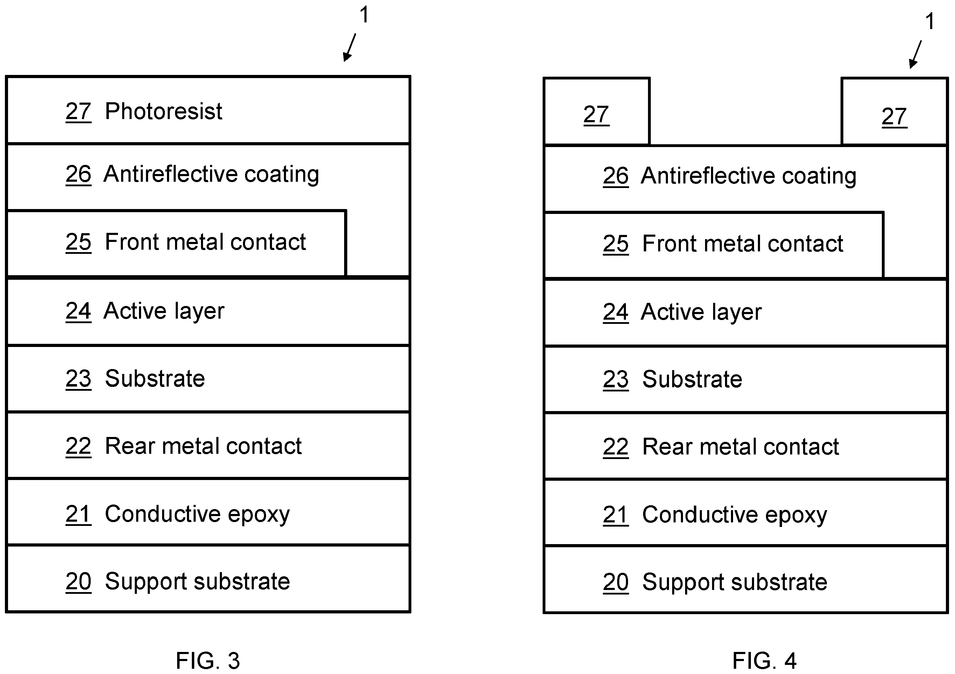

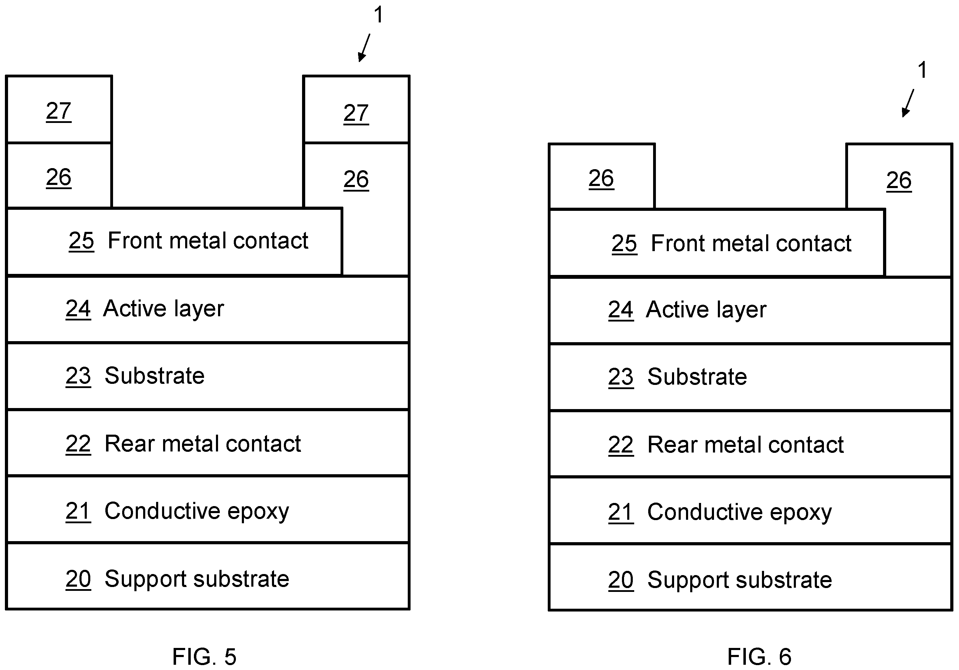

Figs. 3, 4, 5, 6, 7 & 8 are schematic cross-sections across part of a conventional photovoltaic cell during successive stages of a conventional method of bonding an electrical wire to the photovoltaic cell;

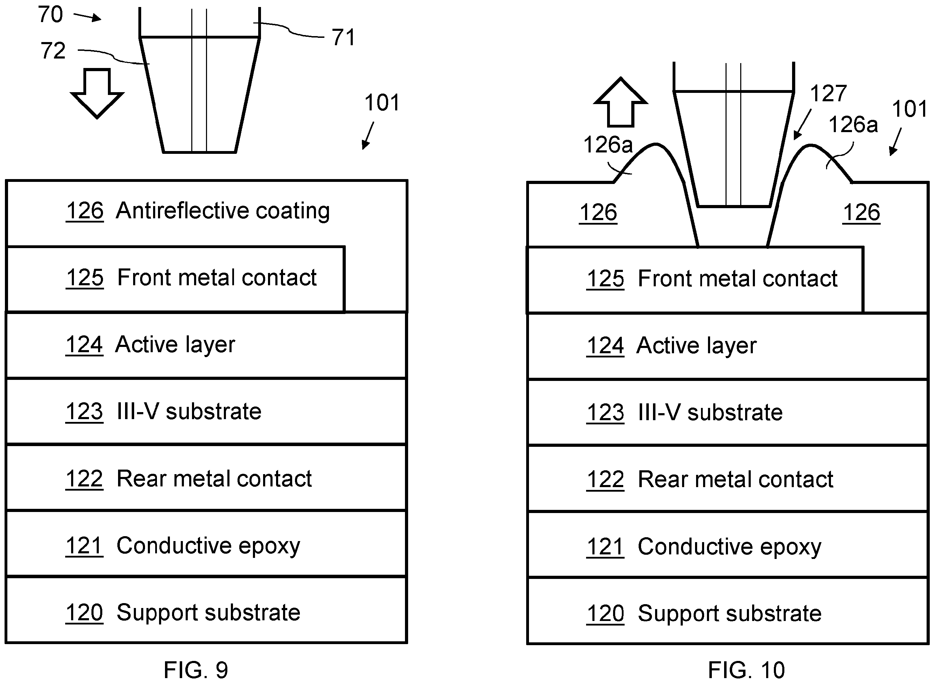

Figs. 9, 10, 11 & 12 are schematic cross-sections across part of a photovoltaic cell during successive stages of a method of bonding an electrical wire to the photovoltaic cell in accordance with an embodiment of the present invention;

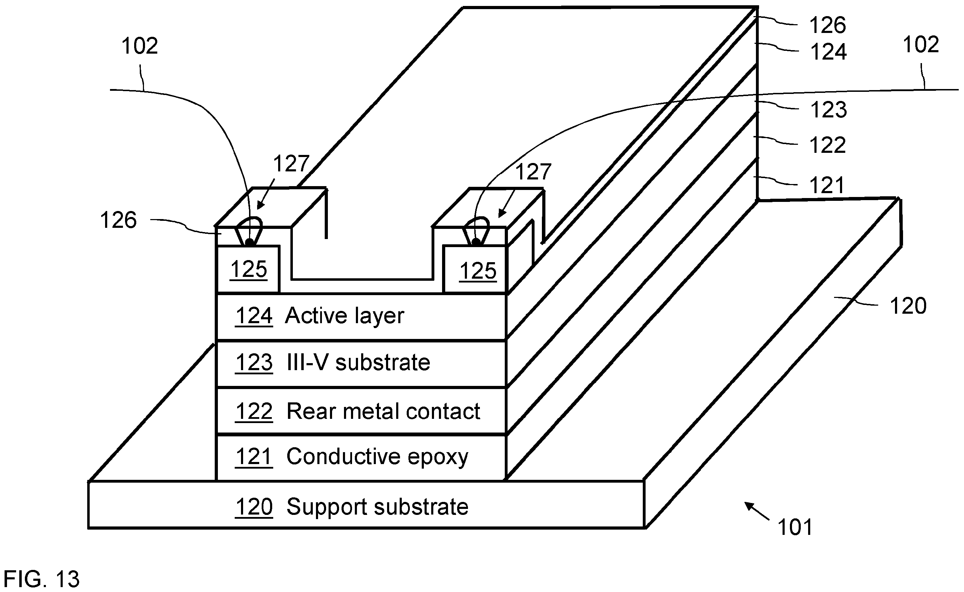

Fig. 13 is a schematic cross-sectional perspective view a photovoltaic cell assembly embodying the invention; and

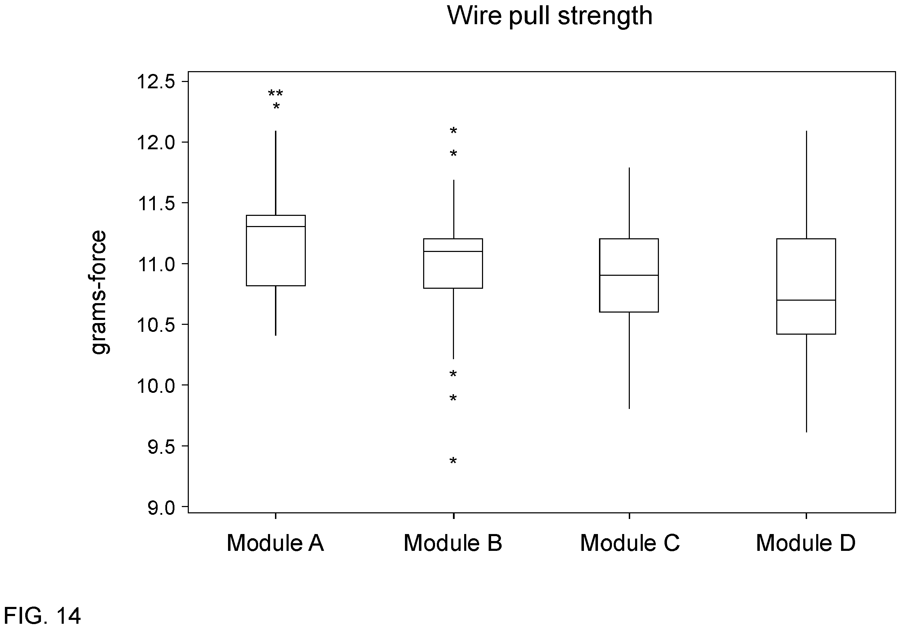

Fig. 14 is a box plot showing wire-bond pull strength values of four different photovoltaic modules prepared in accordance with embodiments of the invention.

The invention may be used in the manufacturing of electronic devices such as transistors and amplifiers.

The invention can also be used in the manufacturing of semiconductor assemblies, for example semiconductor optoelectronic assemblies such as solar panels, comprising one or more semiconductor optoelectronic devices that can convert electrical energy to light energy (light-emitting devices) and/or light energy to electrical energy (light-absorbing devices). The light may be ultraviolet, visible or infrared light.

The semiconductor device may be a semiconductor optoelectronic device. Examples of semiconductor optoelectronic devices and assemblies which have a light-emitting face include light-emitting diodes (LEDs), lasers and organic LEDs. Examples of semiconductor optoelectronic devices and assemblies which have a light-absorbing face include photovoltaic (e.g. solar) cells, photodiodes, photo-resistors, and charge-coupled device (CCD) imaging sensors.

Semiconductor devices often contain one or more dielectric layers. One application of a dielectric layer in an optoelectronic device is as part of an antireflective coating. This can improve the efficiency of the device by reducing the loss of external light incident on a light-receiving face of a light-absorbing device, or the loss of internally-generated light before it reaches a light-emitting face of a light-emitting device. Another application of a dielectric layer in an electronic device is as part of an insulating layer.

One particular example of an optoelectronic device is a photovoltaic cell.

In methods embodying the invention, a photovoltaic cell may be manufactured according to a conventional method, but with the complex, time-consuming and expensive photolithography steps used to form openings in the antireflective coating, to permit access to the front metal contact layer, being replaced by using a conventional wire bonding tip, used in the wire bonding process, to mechanically scratch through the antireflective coating layer.

An example of such a method, applied to the manufacturing of a group III-V photovoltaic cell, is described below with reference to Figs. 9-12.

Fig. 9 shows a thin-film photovoltaic cell 101, which initially has a similar structure to the cell 1 described above with reference to Fig. 1. Layered on top of a support substrate 120 (e.g. a PCB) is: a conductive die-attach epoxy layer 121, a rear metal contact layer 122, a group III-V (e.g. GaAs) substrate layer 123 having an active light-absorbing layer 124, a patterned front metal contact layer 125, and an antireflective coating layer 126. Note that III-V is only indicated by way of nonlimiting example, and other substrates, such as silicon, may be used instead. The patterned front metal contact layer 125 can comprise aluminium, silver, gold, copper, nickel, titanium, germanium, indium, palladium or alloys thereof. The front metal contact layer 125 may have a thickness anywhere between around 10 nm and 100 µm, for example between around 10 nm and 10 µm. The antireflective coating layer 126 may comprise a series of one or more dielectric layers of different refractive indices and thicknesses. Each dielectric layer may have a refractive index in the range one to three.

Fig. 9 shows the wire bonding tip 72 of a conventional bonding tool 70 above the antireflective coating 126 at a point where the antireflective coating 126 overlies a front metal contact 125, and where it is desired to bond a wire. At this stage, no wire is present in the tip 72. Next, as shown in Fig. 10, the wire bonding tip 72 is lowered such that it contacts the antireflective coating 126. Perpendicular pressure is applied so as to create an indentation in the antireflective coating 126 that displaces dielectric material radially outwardly to a sufficient extent that a through-hole opening 127 is created in the coating 126. In some embodiments, the tip 72 may additionally be rotated about an axis of the capillary 71, e.g. in a drilling action, in order to enhance the displacement of material. In some embodiments, the tip 72 may additionally be moved laterally, in the plane of the antireflective coating 126, so as to scratch an elongate opening 127. In some embodiments, the tip may be vibrated relative to the coating 126, e.g. using ultrasound energy. The tip may be vibrated or a support used to support the device during the manufacturing process may be vibrated. In either case, a portion of the front metal contact 125 is exposed by the mechanically-created (i.e. created through physical contact) opening 127 in the antireflective coating layer 126.

The antireflective coating 126 is formed of a dielectric material, for example Si₃N₄ or SiO₂, and is sufficiently thin that it can be displaced using the wire bonding tip 72 without requiring excessive pressure to be applied by the bonding tool 70. The antireflective coating 126 may, in some embodiments, have a thickness of no more than 500 nm, or no more than 100 nm, for example between 40 nm and 70 nm, at least where it is layered on the front metal contact layer 125.

The mechanically-induced opening 127 has a shape defined at least in part by the shape of the bonding tip 72. The opening 127 may have substantially the same cross-section as the wire-bonding tip 72 used to create it. It may have a tapered vertical cross-section that narrows with increasing depth into the cell 101 (i.e. in a perpendicular direction towards the active layer 124). In particular it may have a substantially isosceles trapezoidal cross-section that narrows towards the active layer 124. The opening 127 may have an approximately circular or obround cross-section parallel to the plane of the antireflective coating layer 126. There will typically be some displaced antireflective-coating material forming a heaped lip 126a adjacent an edge of the opening 127 (e.g. around some or all of a perimeter of the opening 127). This can be observed by viewing the opening using a microscope or by using a high resolution step profiler. This contrasts with the geometrically smooth patterning of voids in an antireflective coating layer 26 obtained when using conventional approaches, such as photolithography. The opening 127 formed in the antireflective coating 126 by the present methods is therefore characteristic of the opening having been created by a wire bonding tip 72.

Once the opening 127 has been created through the antireflective coating 126, the wire bonding tip 72 is withdrawn axially away from the device 101. It may remain in place in order to bond a wire 102, or it may optionally be controlled to move laterally to one or more further locations on the cell 101, on other cells, or on to an external support substrate (e.g. a PCB) in order to create further openings, through similar actions, before the actual wire bonding commences. If so, it will subsequently be controlled (e.g. by a robotic arm, operated by computer), to return to a position directly over the present opening 127, in order to start the bonding.

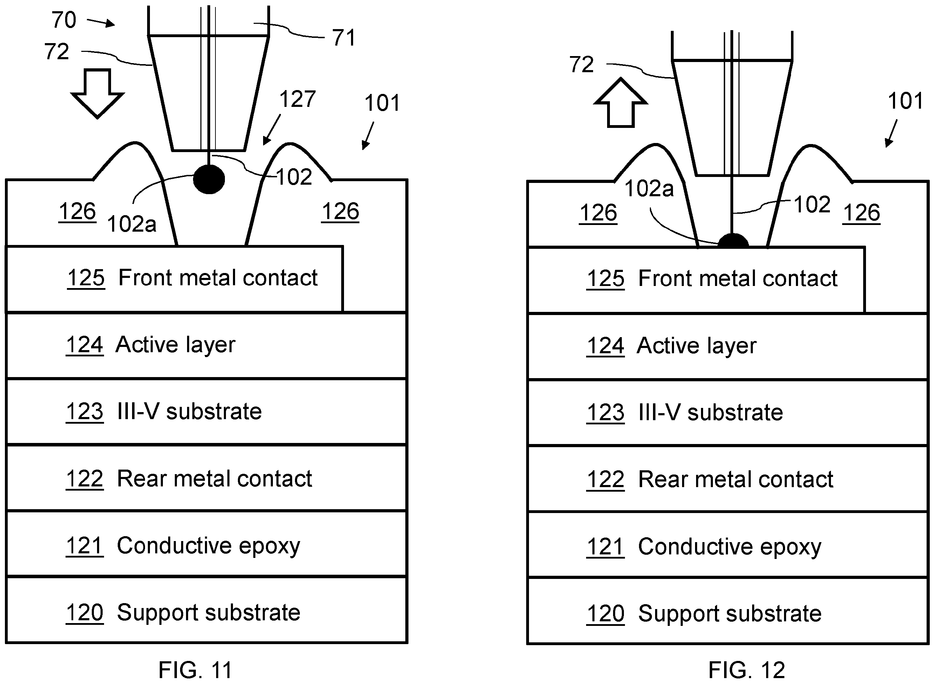

As shown in Fig. 11, a conventional ball-bonding process is then carried out through the opening 127, using the same bonding tip 72 as created the opening 127. This saves time and complexity compared with using a first tool for creating the opening and a second, different tool for bonding the wire 102. A metal wire 102 (e.g. of gold, copper, silver, aluminium, or an alloy thereof) is passed through the capillary 71, and a high voltage is applied to the wire 102 so as to form a ball 102a of metal at the distal end of the wire 102. The wire 102 may have a diameter of between around 10 and 500 µm. The ball 102a may have a diameter of between two and four times that of the wire. The ball 102a is preferably smaller than the bonding tip to improve adhesion at the opening. Adhesion can also be improved by application of pressure or heat, or increasing the ultrasonic energy applied through the tip 72. Once the ball 102a has solidified, it is brought into contact with the exposed portion of front metal contact 125, and the electrical wire 102 is bonded to the surface using heat, mechanical pressure and ultrasound.

The tip 72 is then retracted as shown in Fig. 12, and an electrical connection is made between the front metal contact 125 and another point, such as a pad on the support substrate 120, or the back or front metal contact layer of another similar cell 101', in a conventional manner. This other point may also be made through a further opening in an antireflective coating, created by the same bonding tip 72, although this is not necessarily the case.

Fig. 13 shows a perspective view of a photovoltaic cell assembly comprising the cell 101 and a pair of wires 102, bonded to respective regions of the front metal contact layer 125 through respective mechanically-created openings 127. To improve reliability, further wires may be bonded to these regions of the front metal contact layer (e.g. two wires per region) through further mechanically-created openings. As described above, the openings 127 can be seen to have different cross-sections compared with the voids defined using standard photolithography methods.

### Experimental validation

In order to test the strength of wire bonds formed through openings created as disclosed herein, four photovoltaic assemblies were manufactured identically according to the disclosed methods-Modules A, B, C and D. A gold wire of 1 mil (0.001 inches or 25.4 microns) diameter was bonded to each photovoltaic device through a respective opening mechanically-created by the wire bonding tip, and the wire bond pull strength was tested using the standard methodology "2011.7 Bond strength" described in MIL-STD-883G. In this test, a pull on the wire is applied by inserting a hook under the wire with the device clamped and the pulling force is applied approximately in the centre of the wire in a direction approximately normal to the substrate surface or approximately normal to a straight line between the bond. The test was repeated up to five times for each module.

As shown in the box plots of Fig. 14, the wire bond pull strength achieved by the four modules under test was at least three times higher than the minimum required by the MIL-STD-883G standard, which is 3.0 grams-force for a gold wire of 1 mil (0.001 inches or 25.4 microns) diameter.

The electrical connections formed using the approach disclosed herein are therefore eminently suitable for practical application. Efficient electrical current extraction can be obtained via firmly bonded wires, while reducing the time and cost of the manufacturing process compared with conventional approaches.

Though one particular combination of layers is shown in the figures, this is by way of example only, and one or more of these layers may be omitted or replaced in others embodiments. Additional layers, not shown or described here, may be present, above or below or within the described layers. The same principles for wire bonding may be applied to other types of semiconductor device. In some embodiments, the bonding tip used to create the opening and then bond the wire may be a wedge-bonding tip or a compliant-bonding tip, instead of a ball-bonding tip.

References to the front or top of a device, and to one layer being above or on another layer, are provided for ease of understanding only, and do not imply that the device must only be manufactured or used in any particular orientation.

It will be appreciated by those skilled in the art that the invention has been illustrated by describing certain specific embodiments thereof, but is not limited to these embodiments; many variations and modifications are possible, within the scope of the accompanying claims.

## Claims

1. A method of bonding an electrical wire (102) to a semiconductor device (101), the method comprising:
contacting a tool (70) with a dielectric layer (126) of a semiconductor device (101) so as to mechanically create an opening (127) through the dielectric layer (126); and
using a wire-bonding tip (72) to bond an electrical wire (102) to the semiconductor device (101) through said opening (127).

2. The method of claim 1, wherein the tool (70) is said wire-bonding tip (72).

3. The method of claim 1 or 2, wherein the semiconductor device (101) is a semiconductor optoelectronic device (101).

4. The method of claim 3, wherein the semiconductor optoelectronic device (101) is a photovoltaic cell.

5. The method of any preceding claim, wherein the dielectric layer (126) is an antireflective coating layer (126).

6. The method of any preceding claim, wherein the dielectric layer (126) has a thickness of 10-500 nm and a refractive index between 1 and 3.

7. The method of any preceding claim, wherein the semiconductor device (101) comprises a front metal contact (125) and wherein the wire-bonding tip (72) is used to bond the electrical wire (102) to the front metal contact (125) through said opening (127).

8. The method of any preceding claim, wherein the tool (70) is a tip (72) of a ball-bonding tool (70).

9. The method of any preceding claim, wherein the opening (127) is created by moving the tool (70) only perpendicularly, relative to the dielectric layer (126), while the tool (70) is in contact with the dielectric layer (126).

10. The method of any preceding claim, wherein creating the opening (127) with the tool (70) comprises displacing dielectric material laterally away from the tool (70).

11. A semiconductor assembly comprising:
a semiconductor device (101); and
an electrical wire (102),
wherein the electrical wire (102) has been bonded to the semiconductor device (101) by a method according to any one of the preceding claims.

12. The semiconductor assembly of claim 11, comprising a further semiconductor device (1'), the further semiconductor device (1') comprising a dielectric layer having a further opening mechanically created by said tool (70), wherein the electrical wire (102) is additionally bonded to the further semiconductor device (1') through said further opening.

13. A semiconductor assembly comprising:
a semiconductor device (101); and
an electrical wire (102),
wherein:
the semiconductor device (101) comprises a dielectric layer (126);
the dielectric layer (126) has a mechanically-created opening (127) in the dielectric layer (126); and
the electrical wire (102) is bonded to the semiconductor device (101) through said mechanically-created opening (127).

14. The semiconductor assembly of claim 13, wherein the opening (127) has an isosceles trapezoidal cross-section, perpendicular to the dielectric layer (126), that is widest adjacent an outer face of the semiconductor device (101).

15. The semiconductor assembly of claim 13 or 14, comprising a lip adjacent an edge of the opening (127), wherein the lip stands proud of an outer surface of the semiconductor device (101) and comprises displaced dielectric material.
